**Europäisches Patentamt**

**European Patent Office**

**Office européen des brevets**

(19)

(11) Veröffentlichungsnummer: **0 210 386**
**B1**

(12)

# EUROPÄISCHE PATENTSCHRIFT

(45) Veröffentlichungstag der Patentschrift:
**07.11.90**

(51) Int. Cl.⁵: **H03K 17/96, H01H 13/70**

(21) Anmeldenummer: **86107765.9**

(22) Anmeldetag: **06.06.86**

(54) **Folientastatur mit Piezoelektrischen Tasten.**

(30) Priorität: **23.07.85 CH 3191/85**

(43) Veröffentlichungstag der Anmeldung:
**04.02.87 Patentblatt 87/6**

(45) Bekanntmachung des Hinweises auf die Patenterteilung:
**07.11.90 Patentblatt 90/45**

(84) Benannte Vertragsstaaten:
**AT BE CH DE FR GB IT LI LU NL SE**

(56) Entgegenhaltungen:
**EP-A- 0 107 318**
**DE-A- 2 064 657**
**DE-A- 3 226 350**
**FR-A- 2 455 402**
**US-A- 3 553 588**
**US-A- 3 976 899**
**US-A- 4 137 475**
**US-A- 4 185 621**
**US-A- 4 190 785**

(73) Patentinhaber: **DYNALAB AG, Gewerbestrasse 10,
CH-6330 Cham(CH)**

(72) Erfinder: **Iten, Thomas, Loretohöhe 2, CH-6300 Zug(CH)**

(74) Vertreter: **Blum, Rudolf Emil Ernst et al, c/o E. Blum &
Co Patentanwälte Vorderberg 11, CH-8044 Zürich(CH)**

## Beschreibung

Die Erfindung betrifft eine Tastatur mit piezoelektrischen Tasten gemäß Oberbegriff des Patentanspruches 1.

Es sind bereits zahreiche Drucktastaturen unter Verwendung piezoelektrischer Kristallelemente vorgeschlagen worden. Diese sind vorwiegend als Einzelschalter mit aufwendigen Drahtanschlüssen ausgebildet (vgl. dazu US-PS 3 339 104; 3 553 588; 3 464 531; 3 940 637; 3 976 899; 4 137 475; 4 185 621; DE-OS 2 064 657; 3 226 350). Die Ausbildung von ganzen Tastaturen mittels solcher Einzelschalter erscheint wegen des großen Aufwandes kaum realisierbar.

Wo integrierte Tastaturen mit piezoelektrischen Kristallelementen vorgeschlagen werden, beruhen sie entweder auf piezoelektrischen Folien (US-PS 4 190 875, Kompanek) mit starkem Übersprechen zwischen den einzelnen Tasten (siehe Spalte 6, Tab. 1 von Kompanek) oder auf Einzelelementen, die unterhalb einer Gehäuseoberfläche befestigt sind (EP-A 107 318), die bei jeder Taste Drahtanschlüsse aufweisen und zur Erzielung ausreichender Stabilität und Anschlußsicherheit in Kunstharz eingegossen sind. Solche Tastaturen sind deshalb relativ dick und unhandlich.

Andererseits sind Tastaturen in Folien-Schichtaufbau für passive Schalter (Kontakte oder Widerstände) bekannt. Dabei ist regelmäßig ein erheblicher Tastenweg notwendig, was einen entsprechend elastischen Folienaufbau bedingt (vgl. FR-A 2 455 402, NISSAN; US-PS 4 375 018; 4 207 443; 4 431 882). Mit solchen Tastaturen läßt sich keine ermüdungsfreie Anordnung erzielen, da die Folie und der Tastenkontakt bei jeder Betätigung bewegt und verformt werden, was nach einer gewissen Gebrauchsdauer zu Fehlkontakten oder sogar zu Schäden führen kann.

Es ist somit zu berücksichtigen, daß die vorbekannten Folienstrukturen auf passiven Schaltelementen mit Tastenweg beruhten und deshalb notwendigerweise elastische Strukturen bildeten. Da die Piezokristallelemente mechanisch sehr empfindlich (leicht brechbar) sind, boten sie sich für den Fachmann für die Integration in eine solche elastische Folienstruktur nicht an. Solche Kristallelemente wurden denn auch gemäß dem Stand der Technik regelmäßig in starren Gehäusen untergebracht oder in Kunstharz eingegossen. Passive Schaltelemente in elastischen Folienstrukturen standen damit Piezokristallelementen in starren Gehäusen gegenüber.

Der Erfindung liegt die Aufgabe zugrunde, eine Tastatur mit Folienaufbau zu schaffen, welche die vorstehend erwähnten Nachteile nicht oder nur im verminderten Maße aufweist und bei welcher Piezokristalle in einer Folienstruktur angeordnet werden können.

Dies wird durch eine Tastatur mit den kennzeichnenden Merkmalen des Anspruches 1 erreicht.

Durch die Anordnung von druckempfindlichen Kristallelementen zwischen den Folien können störende Luftkammern weitgehend vermieden werden, und die Betätigung kann praktisch weglos erfolgen. Da die Kristallelemente bei Druckbeaufschlagung aktiv Spannung abgeben, kann auf eine von außen angelegte Spannung verzichtet werden, d.h. im Ruhezustand ist die Tastatur spannungslos.

Im folgenden werden Ausführungsbeispiele der Erfindung anhand der Zeichnung näher erläutert. Dabei zeigt:

Fig. 1 eine perspektivische Ansicht einer Tastatur mit nur teilweise dargestellten Folien;
Fig. 2 einen Längsschnitt durch eine Tastatur ähnlich derjenigen von Fig. 1;
Fig. 3 eine Seitenansicht eines Kristallelementes;
Fig. 4 eine Aufsicht auf ein weiteres Kristallelement;
Fig. 5 eine Schnittansicht einer Ausführungsart der Tastatur mit gewölbtem Kristallelement;
Fig. 6 eine Schnittansicht einer weiteren Ausführungsart der Tastatur;
Fig. 7 eine Schnittansicht einer weiteren Ausführungsart der Tastatur.

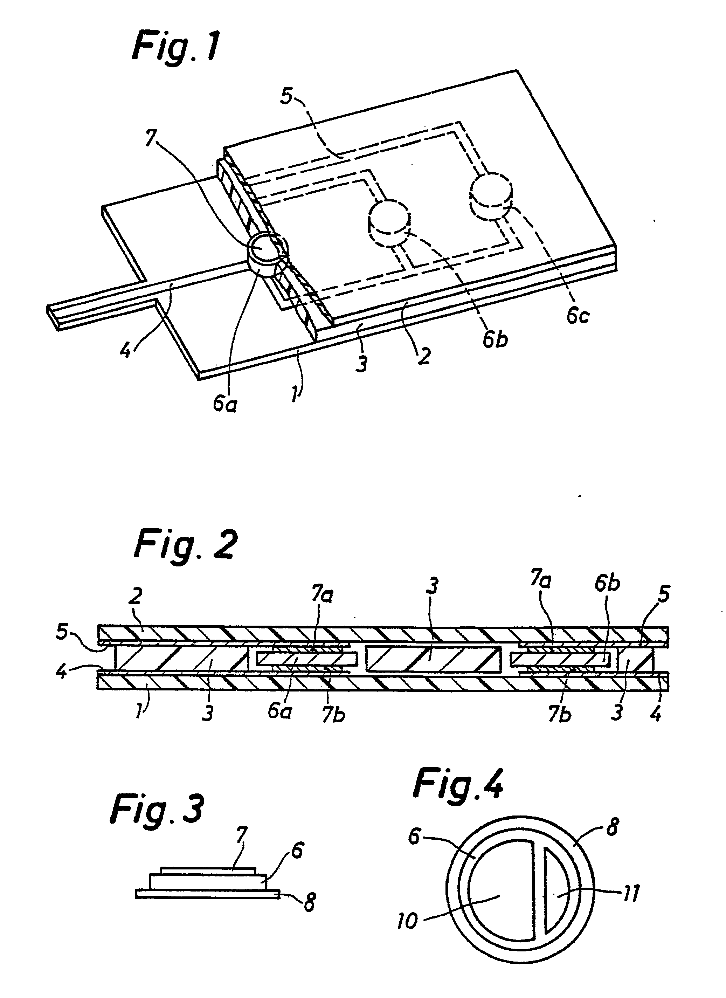

Fig. 1 zeigt eine Folientastatur mit drei Drucktasten, mit den Folien 1, 2, 3 und den Kristallelementen 6a, b, c. Einzelne Folienschichten sind zur deutlichen Darstellung nur teilweise ausgeführt. Die erste Folie 1 bildet eine Auflage für die weiteren Teile der Tastatur und kann aus bekannten Kunststoffmaterialien, z.B. Polyester oder Polycarbonat bestehen. Die Dicke der Folie 1 ist in Fig. 1 vergrößert dargestellt; bei einer typischen Folientastatur beträgt sie ca. 0,1 mm, kann aber in weitem Bereich frei gewählt werden. So kann anstelle der Folie 1 auch eine starre Platte beliebiger Dicke vorgesehen werden. Auf der Folie 1 liegen die Kristallelemente 6a, 6b und 6c an denjenigen Stellen auf, an denen eine Drucktaste gebildet werden soll. Eine Deckfolie 2 wird über den Kristallelementen angeordnet. Eine weitere Folie 3 ist zwischen der Folie 1 und der Deckfolie vorgesehen. Diese Folie 3 weist Ausnehmungen an den vorgesehenen Tastenstellen auf und ihre Dicke entspricht im wesentlichen der Dicke des Kristallelementes mit den zugehörigen Anschlußflächen. Dadurch wird eine gleichmäßig ebene Tastaturoberfläche geschaffen, was in der Regel vorteilhaft ist. Die Folien 1, 3 und 2 werden miteinander verklebt, wobei an den Stellen, an denen sich die Kristallelemente befinden, in der Regel kein Leim vorgesehen wird, um die elektrische Kontaktierung nicht zu stören. Die Dicke der Deckfolie 2 ist in der Darstellung von Fig. 1 ebenfalls vergrößert gezeigt und beträgt typischerweise ca. 0,1 mm. Auch die Dicke der Deckfolie kann in weitem Bereich variiert werden, so lange nur die Funktion der Druckübertragung auf das Element gewährleistet ist. Die Dicke der Folie 3 ist den verwendeten Kristallelementen angepaßt und beträgt z.B. 0,4 mm; diese Folie kann ebenfalls aus einem bekannten Kunststoff gefertigt sein. Für eine normale, mit den Fingern zu betätigende Tastatur beträgt der Durchmesser der Kristallelemente 10 mm, kann aber je nach Verwendungszweck der Tastatur und nach Kristallmaterial im weiten Bereich gewählt werden.

Die Lage der Kristallelemente 6a, 6b, 6c definiert die Tastenbereiche der Tastatur. Bei Druck auf die Deckfolie 2 über einem Kristallelement liegt über dem Kristallelement eine elektrische Spannung, welche, wie nachfolgend genauer beschrieben, vom Element abgegriffen und an einen Anschluß der Tastatur geführt wird.

Als Kristallelemente kommen alle piezoelektrischen Kristalle oder Keramiken, wie z.B. Quarz, Bariumtitanat, Bleizirkontitanat oder weitere bekannte Stoffe mit piezoelektrischen Eigenschaften in Betracht. Auch Siliziumkristalle können vorgesehen werden. Ferner können die verschiedenen Materialien auch kombiniert vorgesehen werden. Zur Erhöhung der bei Druckbeaufschlagung erzeugten Spannung können ferner mehrere Kristallelemente übereinander gestapelt vorgesehen werden, was allerdings die Dicke der Tastatur vergrößert. Bei einer bevorzugten Ausführungsform umfassen eines oder mehrere der Kristallelemente zusätzlich eine Verstärker- oder Logikschaltung. Dazu werden vorzugsweise handelsübliche integrierte Schaltungen zusammen mit den druckempfindlichen Kristallen zwischen den Folien angeordnet. Diese Schaltungen können z.B. zur Auswertung und zur Signalanpassung der Tastaturspannungen an vorgegebene Pegel, z.B. CMOS-Pegel, zur gegenseitigen Verriegelung von Tasten oder zur Codierung der Tasten eingesetzt werden. Um die Tastatur im Ruhezustand spannungslos zu halten, sind diese Schaltungen vorzugsweise mit möglichst geringem Stromverbrauch vorzusehen, was es gestattet, die Schaltungen mit der elektrischen Energie aus dem Kristallelement, d.h. mit der umgewandelten Druckenergie, zu betreiben. Um die Funktion auch bei geringer Tastendruckhäufigkeit zu gewährleisten, können auf der Tastatur ladungsspeichernde Kapazitäten vorgesehen werden. Diese können z.B. von den geeignet beschichteten Folien 1, 2 gebildet werden. Auch eine Anzeigeeinrichtung mit geringer Stromaufnahme, z.B. eine Flüssigkristallanzeige, kann mit der erfindungsgemäßen Tastatur direkt betrieben werden.

Die Kontaktierung der Kristallelemente erfolgt vorzugsweise über Leiterbahnen, welche auf eine oder beide der Folien 1, 2 aufgebracht sind, z.B. mittels eines Druckverfahrens, wie Siebdruck, oder mittels Klebung. In Fig. 1 ist eine Leiterbahn 4 auf der Folie 1 gezeigt, welche alle drei Kristallelemente 6a, 6b, 6c über ihre der Folie 1 zugewandten Flächen miteinander verbindet. Dies entspricht einem gemeinsamen elektrischen Anschluß der Drucktasten. Auf der der Folie 3 zugewandten Fläche der Folie 2 sind getrennte Leiterbahnen 5 angeordnet, welche zu je einer Anschlußfläche 7a der einzelnen Kristallelemente 6a, 6b, 6c führen. Diese Leiterbahnen bilden einen individuellen elektrischen Anschluß für jede Drucktaste. Obschon nur eine Tastatur mit drei Tasten gezeigt ist, können selbstverständlich Tastaturen mit einer größeren Zahl von Tasten in beliebiger elektrischer Verknüpfung gebildet werden. Am Rand der Tastatur können die Leiterbahnen zum Anschluß der Tastatur freigelegt sein, oder die Leiterbahnen können – wie für die Bahn 4 beispielshalber gezeigt – auf einem Folienfortsatz weggeführt werden, der an seinem Ende z.B. mit einem (nicht dargestellten) Steckverbinder versehen wird.

In Fig. 2 ist eine Folientastatur mit zwei Kristallelementen 6a, 6b in Schnittdarstellung gezeigt. Mit 1 ist wiederum die untere Folie bezeichnet und mit 2 die Deckfolie. Die dazwischen liegende Folie 3 weist die genannten Ausnehmungen für die Kristallelemente 6a, 6b auf und hat eine Dicke, welche im wesentlichen der Dicke eines Kristallelementes mit dessen Anschlußflächen 7a, 7b entspricht. Die Anschlußflächen 7a, 7b jedes Kristallelementes bestehen aus leitendem Material, welches auf den Kristall an den ladungstragenden Flächen aufgebracht ist, z.B. mittels Aufdampfen, Drucken oder Kleben mit einem leitenden Klebstoff. Die Anschlußflächen werden von den Leiterbahnen 4 bzw. 5 auf den entsprechenden Folien 1 bzw. 2 kontaktiert. Auf der Deckfolie kann ein Aufdruck oder eine weitere bedruckte Folie aufgebracht werden, welche die Tastenbereiche für den Benützer der Tastatur optisch kennzeichnet. Unterhalb der Folie 1 kann die Tastatur mit einem (nicht dargestellten) mechanischen Element versehen werden, welches der an sich weglosen Tastatur, sofern gewünscht, einen Druckpunkt verleiht. Dieses Element kann auch ein Geräusch erzeugen, welches als Rückmeldung bei gedrückter Taste dient. Da der piezoelektrische Effekt umkehrbar ist (elektrostriktiver Effekt), kann aber bei der erfindungsgemäßen Tastatur eine Rückmeldung auf einfache Weise erfolgen, indem das jeweilige Kristallelement mit einer Wechselspannung angesteuert wird. Somit kann je nach Frequenz der Wechselspannung der Benützer durch ein fühl- oder hörbares Pulsieren oder Schwingen des Kristalls informiert werden.

Fig. 3 zeigt eine Seitenansicht der Kristallelementausführung. Dabei ist der Kristall 6 auf einer Fläche mit einer Anschlußfläche 7 versehen, wie sie bereits beschrieben worden ist. Auf der anderen Fläche ist eine starre Metallscheibe 8 vorgesehen, welche die Funktion der zweiten Anschlußfläche (7b in Fig. 2) übernimmt. Die starre Scheibe bildet eine geeignete Grundfläche für die Druckausübung auf den Kristall 6, insbesondere wenn die Folie 1 sehr dünn ist und somit die Auflage flexibel.

In Fig. 4 wird ein weiteres Kristallelement 6, wiederum mit einer starren Scheibe 8 auf der Unterseite, in Aufsicht gezeigt. Bei diesem Element ist die obere Anschlußfläche in die elektrisch voneinander getrennten Bereiche 10 und 11 aufgeteilt. Bei unterschiedlicher Größe der Bereiche 10 und 11 fällt eine Signalspannung bei Druck auf das Element nicht nur zwischen den Anschlußflächen 10 und 8 sowie 11 und 8 an, sondern auch zwischen den Bereichen 10 und 11. Bei diesem Element können somit nur die Bereiche 10 und 11 kontaktiert werden, was Leiterbahnen nur auf einer der Folien nötig macht, oder es können verschiedene Signalspannungen abgegriffen werden.

Es kann auch ein Kristallelement vorgesehen werden, welches nicht aktiv ein Signal erzeugt, sondern bei Druckbeaufschlagung ein angelegtes Signal verändert. Ein schwingendes Piezokristallelement z.B., welches bei Druckbeaufschlagung die Schwingfrequenz ändert oder ein Piezotransistor, welcher unter Druck Kollektorstrom oder Stromverstärkung ändert.

Wie in den Fig. 2, 5, 6 und 7 gezeigt, ist die jeweilige Ausnehmung für das Kristallelement in der Abstandsfolie 3 größer als das Element gewählt. Dadurch ist das Element um einen bestimmten Betrag verschiebbar, also "schwimmend" zwischen Auflage 1 und Deckfolie 2 gehalten. Dies erlaubt dem Kristall geringe seitliche Ausweichbewegungen bei Biegebelastungen der Tastatur und ermöglicht den dünnen Schichtaufbau ohne Gefahr des Kristallbruches.

Die Abstandsfolie 3 sollte ferner möglichst inkompressibel sein, dies verringert die Gefahr des Uebersprechens zwischen den Tasten. Die Abstandsfolie verhindert ferner den unerwünschten Kontakt der Leiterbahnen 4, 5 und dichtet die Tastatur seitlich gegen Umwelteinflüsse ab.

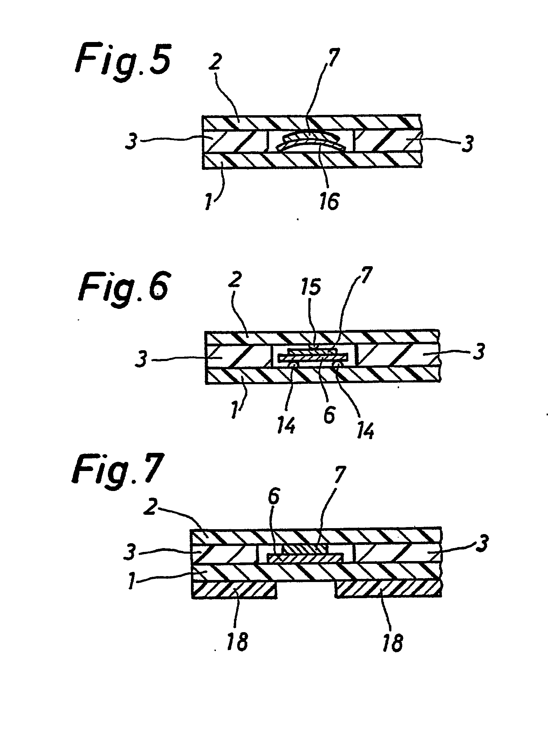

Fig. 5 zeigt schematisch einen Schnitt durch eine weitere Ausführungsart. Mit 1, 2 und 3 sind wiederum Auflage, Deckfolie und Abstandsfolie bezeichnet. Die Leiterbahnen 4, 5 sind in dieser Figur nicht gezeigt (wie auch in den Fig. 6 und 7), doch erfolgt die Kontaktierung des Elementes vorzugsweise ebenfalls über solche Leiterbahnen. Im gezeigten Beispiel kommt ein bombiertes Kristallelement 16 zur Anwendung, was die mechanischen Spannungen im Kristall bei Druckeinwirkung erhöht und somit auch das elektrische Ausgangssignal.

Fig. 6 zeigt ein Ausführungsbeispiel, bei welchem gleiche Bezugsziffern wie zuvor gleiche Bauteile bezeichnen. Die mechanischen Spannungen im ebenen Kristallelement 6 werden bei diesem Beispiel unter Druckeinwirkung erhöht, indem das Element mit seinem Rand auf den Vorsprüngen 14 aufliegt, was eine größere Durchbiegung des Elementes unter Druckeinwirkung ergibt. Die Erhöhungen 14 können auf der Auflage durch ein Druckverfahren oder durch Klebung aufgebracht werden. Die Erhöhungen 14 können auch Teile der Leiterbahnen bilden und das Element 6 kontaktieren. Auch auf der Deckfolie kann eine Erhöhung 15 aufgebracht werden, welche den Fingerdruck auf die Mitte des Elementes konzentriert. Diese Erhöhung kann ebenfalls Teil einer Leiterbahn sein.

Fig. 7 zeigt ein weiteres Ausführungsbeispiel, wobei die Durchbiegung des Elementes 6 dadurch gefördert wird, indem unter der biegsamen Auflage 1 eine weitere Folie oder Platte 18 angeordnet ist, welche unterhalb des mittleren Bereiches des Elementes 6 eine Ausnehmung aufweist.

## Patentansprüche

1. Tastatur mit piezoelektrischen Tasten, welche Tasten auf ihrer Ober- und Unterseite mit elektrischen Kontaktflächen (7, 7a, 7b) versehene Piezokristallelemente (6, 6a, 6b, 6c) aufweisen, dadurch gekennzeichnet, daß die Tastatur einen Schichtaufbau mit einer Auflagefolie (1), einer Mittelfolie (3) und einer Deckfolie (2) aufweist, daß eine der Kontaktflächen (7, 7a, 7b) jedes Piezokristallelementes (6, 6a, 6b, 6c) von einer im wesentlichen starren Scheibe (8) gebildet wird, und wobei jedes Piezokristallelement in seinem Randbereich auf Stützmitteln (14) aufliegt, wodurch das jeweilige Kristallelement bei der Tastenbetätigung auf Biegung beansprucht wird, daß die Mittelfolie (3) von einem im wesentlichen inkompressiblen Material gebildet wird, bei jeder Taste eine Ausnehmung für das Kristallelement aufweist und von einer Dicke ist, welche im wesentlichen der Dicke der Kristallelemente mit ihren Kontaktflächen gleich ist und wobei die Auflage, die Mittelfolie und die Deckfolie miteinander verklebt sind, mit Ausnahme der Bereiche, in welchen die Kristallelemente angeordnet sind.

2. Tastatur nach Anspruch 1, dadurch gekennzeichnet, daß die Auflage (1) und die Deckfolie (2) mit Leiterbahnen (4, 5) zur elektrischen Kontaktierung der Kontaktflächen versehen sind.

3. Tastatur nach Anspruch 2, dadurch gekennzeichnet, daß die Leiterbahnen (5) auf der Deckfolie (2) im Zentrum jedes Tastenbereiches eine Ausformung (15) aufweisen.

4. Tastatur nach Anspruch 2 oder 3, dadurch gekennzeichnet, daß die Stützmittel von Ausformungen (14) der Leiterbahnen (4) auf der Auflage (1) gebildet werden.

5. Tastatur nach einem der vorangehenden Ansprüche, dadurch gekennzeichnet, daß das Kristallelement von einem Piezoquarzkristallelement und/oder einem Piezokeramikelement und/oder einem Siliziumkristallelement gebildet wird.

6. Tastatur nach Anspruch 5, dadurch gekennzeichnet, daß das Kristallelement eine Verstärker- und/oder Logikschaltung umfaßt.

7. Tastatur nach Anspruch 6, dadurch gekennzeichnet, daß die Schaltung mit der elektrischen Energie aus dem Kristallelement betreibbar ist.

8. Tastatur nach einem der vorangehenden Ansprüche, dadurch gekennzeichnet, daß mehrere Kristallelemente übereinander angeordnet sind.

9. Tastatur nach einem der vorangehenden Ansprüche, dadurch gekennzeichnet, daß im Tastenbereich ein mechanisches Element vorgesehen ist zur Definition eines Tastaturdruckpunktes.

10. Tastatur nach einem der vorangehenden Ansprüche, dadurch gekennzeichnet, daß das Kristallelement aktiv ansteuerbar ist zur Erzeugung eines hör- und/oder fühlbaren Rückmeldesignals.

11. Tastatur nach einem der vorangehenden Ansprüche, dadurch gekennzeichnet, daß die Ausnehmung für das Kristallelement (6a, 6b) in der Mittefolie (3) einen Durchmesser aufweist, welcher größer als der Durchmesser des Kristallelementes ist.

12. Tastatur nach einem der vorangehenden Ansprüche, dadurch gekennzeichnet, daß das Kristallelement (16) eine Wölbung aufweist.

13. Tastatur nach einem der vorangehenden Ansprüche, dadurch gekennzeichnet, daß die Deckfolie eine Dicke aufweist, welche bei der Tastenbetätigung eine Druckübertragung auf das Kristallelement im wesentlichen ohne Verformung der Deckfolie ermöglicht.

## Claims

1. A keyboard having piezoelectric keys, said keys comprising piezoelectric crystal elements (6, 6a, 6b, 6c) provided with electric contact areas (7, 7a, 7b) at their upper and lower surfaces, characterized in that said keyboard has a layer structure comprising a support layer (1), an intermediate layer (3) and a cover layer (2), that one of said contact areas (7, 7a, 7b) of each piezoelectric crystal element is a substantially rigid plate (8), and wherein each piezoelectric crystal element is supported at its periphery on supporting means (14), whereby the respective crystal element is subjected to bending stress upon actuation of a key, and that said intermediate layer (3) is made of a substantially incompressible material and has an opening at each key location for receiving said crystal element and has a thickness which substantially corresponds to the thickness of said crystal elements including their contact areas, and that said support layer, said intermediate layer and said cover layer are glued to each other except at the locations where said crystal elements are arranged.

2. Keyboard according to claim 1, characterized in that said support layer (1) and said cover layer (2) are provided with conducting strips (4, 5) for electrically contacting said contact areas.

3. Keyboard according to claim 2, characterized in that said conducting strips (5) on said cover layer (2) are provided with a projection (15) at the center area of each key location.

4. Keyboard according to claim 2 or 3, characterized in that said supporting means are formed by projections of said conducting strips (4) on said support layer (1).

5. Keyboard according to one of the preceding claims, characterized in that said crystal element is a piezoelectric quartz crystal element and/or a piezoelectric ceramic element and/or a silicon crystal element.

6. Keyboard according to claim 5, characterized in that said crystal element comprises an amplifier circuit and/or a logic circuit.

7. Keyboard according to claim 6, characterized in that said circuit is operational with the energy from said crystal element.

8. Keyboard according to one of the preceding claims, characterized in that several crystal elements are stacked on each other.

9. Keyboard according to one of the preceding claims, characterized in that a mechanical element is provided at said key location for providing a pressure feedback point to said keys.

10. Keyboard according to one of the preceding claims, characterized in that said crystal element can be driven actively for generating an audible and/or tactile acknowledging signal.

11. Keyboard according to one of the preceding claims, characterized in that said opening for said crystal element (6a, 6b) in said intermediate layer (3) has a greater diameter than the diameter of said crystal element.

12. Keyboard according to one of the preceding claims, characterized in that said crystal element (16) is dish-shaped.

13. Keyboard according to one of the preceding claims, characterized in that said cover laminate has a thickness which upon actuation of a key allows a pressure transmission to said crystal element substantially without deformation of said cover layer.

**Revendications**

1. Clavier comprenant des touches piézo-électriques, qui présentent sur leurs faces supérieure et inférieure des éléments à cristaux piézo-électriques (6, 6a, 6b, 6c) qui sont pourvus de surfaces de contact éléctriques (7, 7a, 7b), caractérisé en ce que le clavier présente une structure en couches comprenant un film d'enduction (1), un film intermédiaire (3) et un film de recouvrement (2), en ce que l'une des surfaces de contact (7, 7a, 7b) de chaque élément à cristaux piézo-électriques (6, 6a, 6b) est formée par une plaque sensiblement rigide (8), chaque élément à cristaux piézo-électriques étant en appui dans sa zone de bord sur des moyens d'appui (14), ce qui a pour effet que chaque élément à cristaux est sollicité en flexion lors de l'actionnement des touches, en ce que le film intermédiaire (3) est formé par une matière sensiblement incompressible, que celui-ci présente pour chaque touche un évidement destiné à l'élément à cristaux et que celui-ci présente une épaisseur qui est sensiblement égale à l'épaisseur des éléments à cristaux comprenant leurs surfaces de contact, l'enduction, le film intermédiaire et le film de recouvrement étant collés l'un à l'autre à l'exception des zones dans lesquelles les éléments à cristaux sont agencés.

2. Clavier suivant la revendication 1, caractérisé en ce que l'enduction (1) et le film de recouvrement (2) sont pourvus de pistes conductrices (4, 5) destinées à l'établissement d'un contact électrique des surfaces de contact.

3. Clavier suivant la revendication 2, caractérisé en ce que les pistes conductrices (5) présentent sur le film de recouvrement (2) et au centre de chaque zone de touche un élément en saillie (15).

4. Clavier suivant la revendication 2 ou 3, caractérisé en ce que les moyens d'appui sont formés par des éléments en saillie (14) des pistes conductrices (4) sur l'enduction (1).

5. Clavier suivant l'une quelconque des revendications précédentes, caractérisé en ce que l'élément à cristaux est formé par un élément à cristaux piézo-électriques et/ou par un élément en céramique piézo-électrique et/ou par un élément à cristaux de silicium.

6. Clavier suivant la revendication 5, caractérisé en ce que l'élément à cristaux comprend un amplificateur et/ou un circuit logique.

7. Clavier suivant la revendication 6, caractérisé en ce que le circuit peut être activé par l'énergie électrique de l'élément à cristaux.

8. Clavier suivant 1, une quelconque des revendications précédentes, caractérisé en ce que plusieurs éléments à cristaux sont agencés l'un au-dessus de l'autre.

9. Clavier suivant l'une quelconque des revendications précédentes, caractérisé en ce qu'il est prévu dans la zone de touche un élément mécanique destiné à déterminer un point d'impact du clavier.

10. Clavier suivant l'une quelconque des revendications précédentes, caractérisé en ce que l'élément à cristaux peut être activé pour la production d'un signal-témoin de retour audible et/ou sensible au toucher.

11. Clavier suivant l'une quelconque des revendications précédentes, caractérisé en ce que l'évidement destiné à l'élément à cristaux (6a, 6b) présente dans le film intermédiaire (3) un diamètre qui est supérieur à celui de l'élément à cristaux.

12. Clavier suivant l'une quelconque des revendications précédentes, caractérisé en ce que l'élément à cristaux (16) présente un bombement.

13. Clavier suivant l'une quelconque des revendications précédentes, caractérisé en ce que le film de recouvrement présente une épaisseur qui permet lors de l'actionnement d'une touche un transfert de pression sur l'élément à cristaux sensiblement sans déformation du film de recouvrement.

EP 0 210 386 B1

Fig. 1

Fig. 2

Fig. 3

Fig. 4

Fig.5

Fig.6

Fig.7